Europäisches Patentamt

(19) European Patent Office

Office européen des brevets

(11) Publication number: **0 018 211**
**B1**

(12) # EUROPEAN PATENT SPECIFICATION

(45) Date of publication of patent specification: **07.03.84**

(21) Application number: **80301240.0**

(22) Date of filing: **17.04.80**

(51) Int. Cl.³: **G 11 B 7/08,** G 11 B 7/12 //H01L27/14

(54) Tracking arrangement for a sensor of signals on an information track.

(30) Priority: **18.04.79 US 31252**

(43) Date of publication of application:
**29.10.80 Bulletin 80/22**

(45) Publication of the grant of the patent:
**07.03.84 Bulletin 84/10**

(84) Designated Contracting States:
**AT BE CH DE FR GB IT LI LU NL SE**

(56) References cited:
**BE - A - 831 264
DE - A - 2 033 557
DE - A - 2 337 494
FR - A - 2 312 091
US - A - 3 158 846
US - A - 3 739 154
US - A - 3 769 465
US - A - 3 780 266
US - A - 3 931 459
US - A - 4 047 022**

(73) Proprietor: **DISCOVISION ASSOCIATES
P.O. Box 6600 3300 Hyland Avenue
Costa Mesa California 92626 (US)**

(72) Inventor: **Basilico, Albert Richard
12, Apple Tree Drive
Hyde Park New York 12538 (US)**
Inventor: **Wilfinger, Raymond John
17, Square Woods Drive
LaGrangeville New York 12540 (US)**

(74) Representative: **Arthur, George Fitzgerald et al,
KILBURN & STRODE 30, John Street
London WC1N 2DD (GB)**

Courier Press, Leamington Spa, England.

## Tracking arrangement for a sensor of signals
## on an information track

The present invention relates to tracking arrangements for optical sensing devices for signals on an information track for example a spiral track on a video disc or a computer memory.

In certain optical disc players optical sensing of a spiral track — alternatively circular tracks — on the disc is accomplished by reflecting light off the surface of the disc and onto a photo-optic sensor. One way of tracking in such an optical recorder is to move the photo-optic sensor radially inward as the disc rotates so the photo-optic sensor scans the entire disc. One problem with such a tracking and sensing system is that because of manufacturing tolerances and other problems the spiraling of the track is not uniform but has eccentricities. These eccentricities cause cross talk in the optically sensed data and also cause the skipping of certain sections of the track while repeating other sections of the track.

In the past, many systems have been proposed to permit the photo-optic sensor to track data recorded with the described eccentricities. One such tracking system involves the use of mirrors. As shown in United States Korpol Patent No. 3,931,459, a mirror directs light through a disc into two photo sensitive devices to generate outputs which are summed to generate the output for the video disc player and which are subtracted to generate a tracking control signal for positioning the mirror.

In accordance with the present invention, a tracking arrangement for an optical sensor of signals on information tracks for example a circular or helical track on a video or data disc or a computer memory, comprising an array of sensor devices arranged to be disposed transversely in relation to the track, and means to select a pair of adjacent sensor devices summing means responsive to the output signals of the selected pair of sensor devices to provide a first signal representative of the information on the track, and difference means responsive to two sensor devices to derive a difference signal and to provide a second signal for controlling which pair of two adjacent sensor devices are selected, is characterised in that: a first set of alternate devices in the array are capable of connection to a first output, and a second set of the intermediate devices are capable of connection to a second output (22); said summing and difference means are responsive to the first output and the second output; and said array of sensor devices is on a single chip having an elongate anode layer common to all the sensor devices and a number of cathode layers spaced apart along the length of the anode layer, each cathode layer being an elongate strip extending away from the anode layer, alternate strips extending to opposite sides.

Corcran's U.S. Specification No. 3,739,154 discloses an optical tracking apparatus which uses the output signals from the same three sensors for determining which sensors the output signal is to be derived from, and this requires that the sensors are spaced at a fixed integral multiple of the track spacing. The sensor selecting signals may be based on movement of an unread track adjacent the three sensors, and since there may be flaws in the medium resulting in tracks not being parallel with each other, movement of an unread track does not necessarily conform to movement in the track being read.

The present invention derives sensor selecting signals based on movement of the actual track being read relative to the sensors reading that track.

The invention may be carried into practice in various ways, and one embodiment will be described by way of example, with reference to the accompanying drawings, in which:—

FIGURE 1 is a schematic diagram of the video disc player;

FIGURE 2 is a circuit diagram of control logic shown in block form in Figure 1;

FIGURE 3 is a circuit diagram of the gate decoding circuit shown in block form in Figure 2; and

FIGURE 4 is a plan view of a part of the photo-optic sensor chip used in Figure 1.

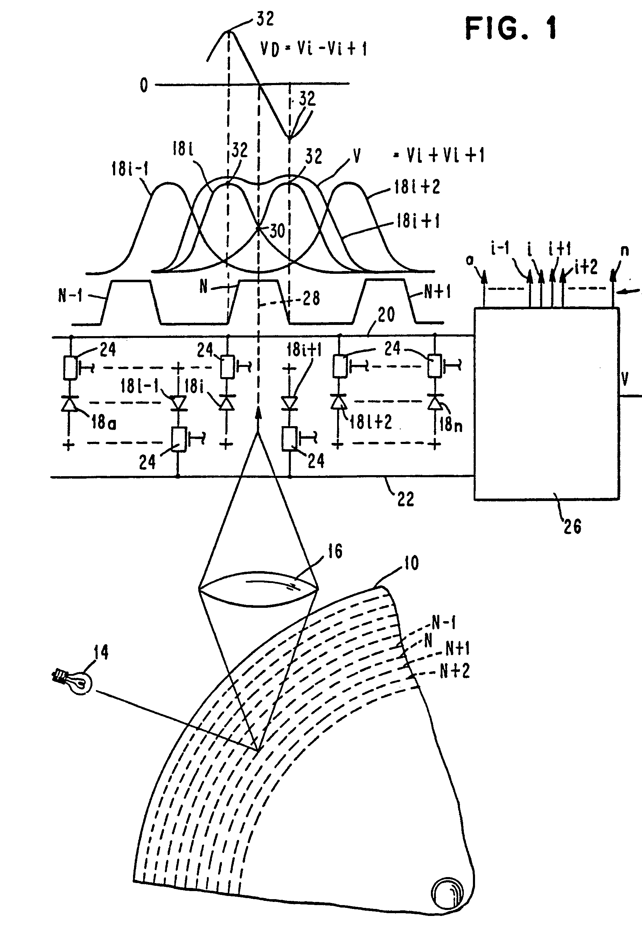

Referring to Figure 1, a disc 10 with a spiralling track 12 of digitally encoded information on it is illuminated by a light source 14. Light reflected off the encoded information in the track provided is more intense than that reflected off the guard bands between the turns of the track. This reflected light passes through a magnifying lens 16 and is focused on an array of diodes 18. There are 128 diodes in two sets of sixty four.

The diodes of the array are arranged in a string. Electrical connections to adjacent diodes in the string are made to two different output lines 20 and 22 on opposite sides of the string. The diodes 18 are each coupled to one of the lines 20 or 22 through an enhancement mode field effect transistor (FET) 24. At any one time only two of the FET's are biased conductive to electrically connect one diode $18_i$ to line 20 and another diode $18_{i+1}$ to line 22. These two diodes are adjacent to each other and have their outputs summed by the logic circuitry 26 to generate the video output signal V Out.

The logic circuitry 26 not only provides the output signal for the video player but it also generates selection signals on decode lines 27 for the gates of the devices 24 that connect the two diodes $18_i$ and $18_{i+1}$ to the lines 20 and 22. To this end the logic circuitry 26 generates an up or high level signal on two and only two decode lines 27 thereby biasing two FET's 24

on and provides down voltages on all the other decode lines 27 to maintain all the other FET's 24 biased off.

The selection of the two diodes 18 is made on the basis of which two diodes in the array are in position to optically sense the desired portion of the spiralling track.

To understand this, let us assume that the two diodes $18_i$ and $18_{i+1}$ are optically centered over the Nth revolution of the track and electrically connected to the lines 20 and 22 respectively. The diodes $18_i$ and $18_{i+1}$ would then be operating at point 30 of their output curves. When operating at this point, neither diode $18_i$ nor $18_{i+1}$ is sensitive to light from adjacent tracks $N - 1$ or $N + 1$. If the spiral of the track were true, movement of the sensor across the record by mechanical devices alone would be sufficient to maintain the diodes $18_i$ and $18_{i+1}$ in registration with the track as it spirals inwardly. However, since the position where the light from track N hits the diodes array 18 changes considerably due to record eccentricities, it is possible that either diode $18_i$ and $18_{i+1}$ will start reading adjacent tracks $N - 1$ or $N + 1$. For instance, if the light reflected from revolution N were to move to the other side of diode $18_i$ light reflected from revolution $N + 1$ would fall within the operating spectrum of diode $18_{i+1}$. However, the position which reflected light from track N hits the sensor can be allowed to vary considerably without changing either of the diodes $18_i$ or $18_{i+1}$ which supply the two components of the output signal. In fact, the point at which light from the center track N hits the array of diodes can change from the center of diode $18_i$ to the center of diode $18_{i+1}$ without picking up light from adjacent tracks $N - 1$ and $N + 1$ with diode $18_i$ or $18_{i+1}$. Larger drifts than this can result in picking up data from adjacent tracks and for this reason the diodes producing the two components of the output signal are changed with such larger drifts.

The difference voltage VD, between the two output voltages $V_i$ and $V_{i+1}$ corresponding to the currents from the diodes $18_i$ and $18_{i+1}$ is used to determine when changes in diodes are to be made.

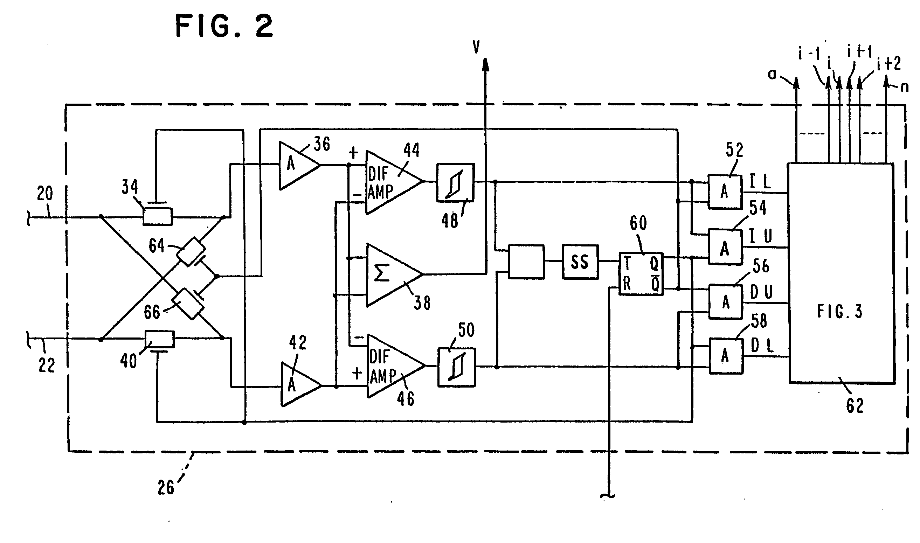

At point 30 on their operating curves the diodes $18_i$ and $18_{i+1}$ produce outputs which are identical so that the difference voltage VD is equal to zero. However, let us assume that the light from track N drifts because of some eccentricity of the disc. The one diode would produce a larger output signal than the other diode. The present invention makes use of this increase in the difference voltage to switch the exciting voltage on the gate of the devices 24 coupling the diodes 18 to the lines 20 and 22. The diodes 18 are spaced so that the operating spectra of the diodes are each as wide as the track or the guard band between the tracks. Therefore, the voltage difference VD will increase until either diode $18_i$ or $18_{i+1}$ is

optically centered over the track. VD max can then therefore be used to change the combination of diodes 18 used to produce the output signal. Referring to Figure 2, we can see how this is done. For a moment let us again assume that the circuit is operating with diodes $18_i$ and $18_{i+1}$ supplying the signals generating the output signal V Out. The output of $18_i$ is produced on lines 20, fed through device 34, and gain amplifier 36 and into the summing amplifier 38 while the output of device $18_{i+1}$ is put on line 22, passed through conductive device 40, and amplifier 42 and fed to the other input of the summing amplifier 38 to thereby produce the output signal V Out.

The output signals are also differentially summed in differential amplifiers 44 and 46. In differential amplifier 44 the signal coming through amplifier 36 is positive in the summation while in the differential amplifier 46 the signal coming through amplifier 42 is positive in the summation. The differential sum outputs are fed to trigger circuits 48 and 50. The threshold level for these trigger circuits is set at a point equal to or slightly less than the maximum output points 32 in the operating curves of the two diodes $18_i$ and $18_{i+1}$. Therefore, so long as the light is directed between the two diodes $18_i$ and $18_{i+1}$, there will be no pulse produced by the trigger circuits 48 or 50 and the outputs on lines 20 and 22 are the signals from diodes $18_i$ and $18_{i+1}$ respectively. However, now assume that light from the center of the track N drifts to the left so that it is directed at diode $18_i$ or beyond diode $18_i$. Then trigger circuit 48 will produce a pulse. Alternatively, if it is detected at diode $18_{i+1}$ or beyond diode $18_{i+1}$, trigger circuit 50 will produce a pulse. These pulses will be used to generate decode signals that will shift the two up voltages on gate lines i and i + 1 one line in either direction.

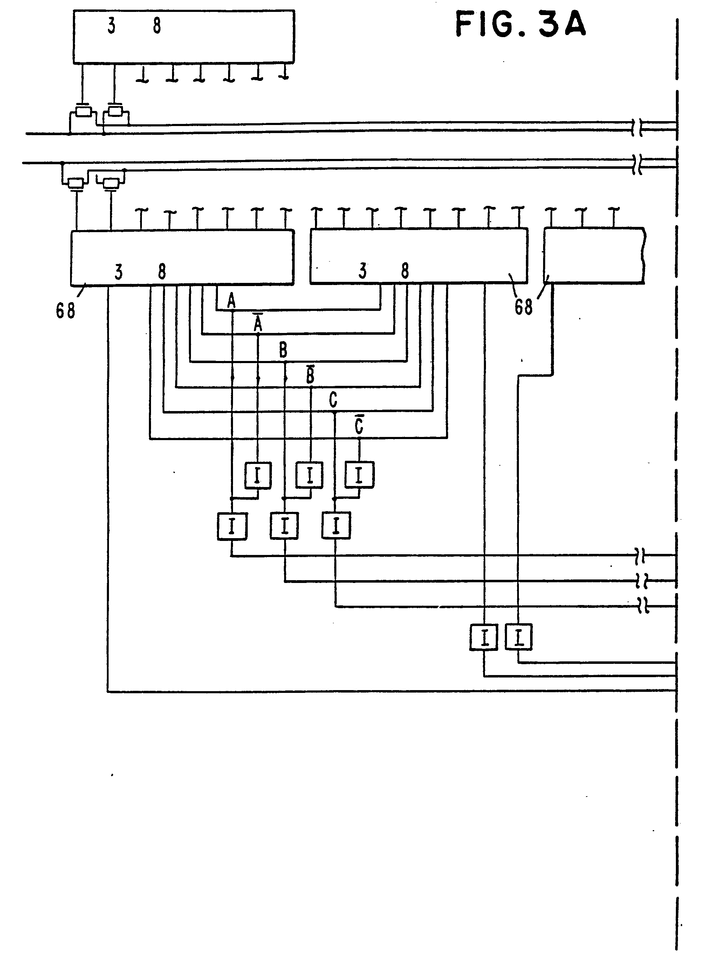

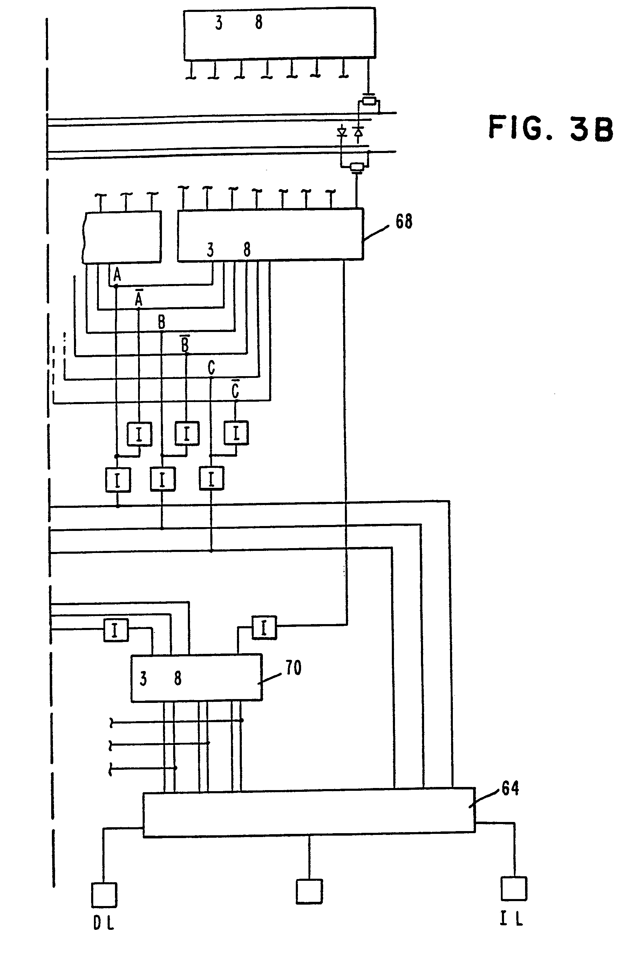

The AND gates 52, 54, 56 and 58 and flip flop circuit 60 generate those decode signals. The output of both trigger circuits 48 and 50 are coupled to the trigger input of flip flop 60. The output of trigger circuit 48 is fed to one terminal of two input AND gates 52 and 54, and the output of trigger circuit 50 is fed to one terminal of AND gates 56 and 58. The other terminal of AND gates 54 and 58 is the Q output of the flip flop 60 and the other input to the AND gates 52 and 56 are the $\overline{Q}$ output of the flip flop 60. Each time one of the trigger circuits 48 and 50 produces a pulse one and only one of the AND gates 52 to 58 produces a pulse. This pulse disconnects either diode $18_i$ from line 20 or diode $18_{i+1}$ from line 22 and connects either diode $18_{i+2}$ to line 20 or diode $18_{i-1}$ to line 22 resulting in the shift of the conducting diodes one diode position in either direction along the diode string. This will be discussed in more detail with references to Figure 3.

The outputs Q and $\overline{Q}$ also control whether the signal on line 20 is fed to amplifier 36 or 42 and whether the signal on line 22 is fed to amplifier 36 or 42. For instance, let us assume that the flip flop 60 is in its Q state while diodes $18_i$ and $18_{i+1}$ are conducting and the track position shifts sufficiently to cause trigger circuit 48 to produce a pulse. This pulse will be fed to the trigger terminal of flip flop 60 switching the flip flop from its Q state to its $\overline{Q}$ state. With the flip flop 60 in the $\overline{Q}$ state devices 64 and 66 will be rendered conductive and devices 34 and 40 will be rendered non-conductive. The effect of this is to couple diode $18_{i+1}$ to the amplifier 36 and diode $18_{i-1}$ to the amplifier 42.

In the decoding circuitry 62, the signals generated by AND gates 52 through 58 control the count on two counters. As shown in Figure 3, the output of AND gate 52 is coupled to the increment input to the counter 64 and the output of AND gate 58 is coupled to the decrement input to the counter 64 associated with the lower line 22. The counter 64 is a six bit up/down counter. The production of a pulse by AND gate 52 will increase the count in the counter by one and production of the pulse by AND gate 58 will decrease the count in the counter by one. The true and complements of the three low order bits of counter 64 are generated and fed to the inputs of eight separate 3 to 8 decoders 68. The true and complement of the three high order bits of counter 64 are fed to the inputs of another 3 to 8 decoder 70. Each of the eight outputs of the decoder 70 is a gating signal for one of the decoders 68 so that with each count of the counter, the decoder 70 selects and activates one and only one of the decoders 68 using the high order digits of counter 64 and then the lower oder bits of the counter are used to place a positive voltage on one and only one output of the activated decoder 68. Each of the eight outputs from the decoder 68 is connected to control a different one of the devices 24, so that a different one of the 64 diodes 18 is connected to the line 22 with each count. The decode circuitry associated with the upper line 20 is identical to those controlling the connections to the lower line, with the exception that the AND gate 54 drives the increment input and AND gate 56 drives the decrement input to the counter associated with the upper line 20.

Figure 1 shows how the summed output $V_i + V_{i+1}$ does not vary much in amplitude over the range between adjacent peaks 32.

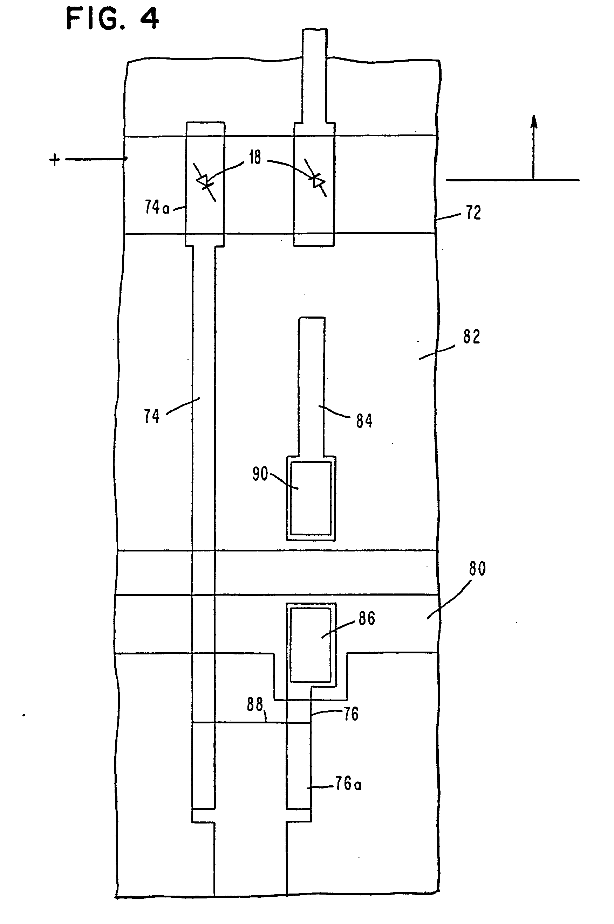

Figure 4 shows a layout of a diode 18 and its associated connections for the lower half of the sensor. The layout for a diode 18 in the upper half of the sensor is the mirror image of the layout shown here. A substrate of 'P' type material contains a number of 'N' type diffusions. The diffusion 74 contains an enlarged portion $74_a$ which functions as the cathode of the diode 18. The other end of the diffusion 74 is the source of the FET 24 coupling the diode to the line 22. The narrow end $76_a$ of a diffusion 76 forms the drain of the FET 24. A metalisation pattern 88 overlying the diffusions 74 and 76 on an insulating layer forms the gate for the device and the coupling to the gate decode logic 68. A second metalisation pattern 80 on the insulating layer forms the line 22. The line 22 is connected to the drain of the FET 24 by a metal connection 86 through the insulating layer. A third metalisation pattern 82 forms a line which overlies and is connected to a diffusion 84 by a metal connection 90 through the insulating layer to form a FET for voltage clamping purposes. A second insulating layer covers all of the chip and it is covered by a second metalisation layer which covers the whole chip except the diodes 18 at 72 to shield the circuitry from light. 72 indicates a window for light to all the diodes 18 and also the position of a diffusion layer constituting a common anode for all the diodes.

Above has been described one of the embodiments of the invention. A number of changes can be made in this embodiment. For instance, in the described embodiment the 128 diodes 18 of the sensor are driven by mechanical means to move radially across the face of the disc to be in the region where the light from 14 is being reflected. A longer stationary string of diodes 18 could be used to read the whole disc without movement and avoid the use of a drive mechanism. Also in the discussion it was assumed that the track provided a more intense reflection than the surrounding guide bands. The present invention would work equally as well if the opposite were true.

## Claims

1. A tracking arrangement for an optical sensor of signals on information tracks (N), for example a circular or helical track on a video or data disc or a computer memory, comprising an array of sensor devices (18) arranged to be disposed transversely in relation to the track, and means (24) to select a pair of adjacent sensor devices (e.g. 18i and 18i + 1) summing means (38) responsive to the output signals of the selected pair of sensor devices to provide a first signal representative of the information on the track, and difference means (44, 46) responsive to two sensor devices to derive a difference signal and to provide a second signal for controlling which pair of two adjacent sensor devices are selected, characterised in that: a first set of alternate devices ($18_i$, $18_{i+2}$) in the array are capable of connection to a first output (20), and a second set of the intermediate devices ($18_{i-1}$, $18_{i+1}$) are capable of connection to a second output (22); said summing and difference means (26) are responsive to the first output (20) and the second output (22); and said array of sensor devices is on a single chip having an elongate anode layer (72) common to all the sensor devices and a number of cathode layers (74a) spaced apart along the length of the anode layer, each cathode layer being an elongate strip extending away from the anode layer, alternate strips extending to opposite sides.

2. A tracking arrangement as claimed in Claim 1 including a generator (48, 50) of a trigger signal in response to the difference signal being in excess of a pre-set value.

3. A tracking arrangement as claimed in Claim 2 including a counter (64) of said trigger signals, and a decoder (62) in which the second signal is derived from the count of the counter.

4. A tracking arrangement as claimed in Claim 3 including a controllable switch (24) for each sensor device responsive to the output of the decoder and capable of connecting said sensor device to its output (20 or 22).

5. A tracking arrangement as claimed in any preceding claim including a common window (72) for all the cathode layers where they are opposite the anode layer.

6. A tracking arrangement as claimed in any preceding claim, in which the single chip has output layers (80) defining the two outputs one at each side of the anode layer and each cathode layer extends adjacent one of the output layers.

7. A tracking arrangement as claimed in Claim 6 in which the common chip defines a controllable semi-conductor switching device (74, 88, 76a) for connecting each cathode diffusion to its output layer.

**Revendications**

1. Dispositif de guidage pour un capteur optique de signaux sur des pistes de données (N), par exemple une piste circulaire ou hélicoïdale sur un vidéodisque ou un disque de données ou une mémoire de calculateur, comprenant un agencement de dispositifs capteurs (18) agencés pour être disposés transversalement par rapport à la piste, et un moyen (24) pour choisir une paire de dispositifs capteurs adjacents (comme 18i et 18i + 1), un moyen d'addition (38) répondant aux signaux à la sortie de la paire choisie de dispositifs capteurs pour produire un premier signal représentatif de l'information sur la piste, et un moyen de différence (44, 46) répondant aux deux dispositifs capteurs pour dériver un signal de différence et produire un second signal pour contrôler laquelle paire de deux dispositifs capteurs adjacents est choisie, caractérisé en ce que: un premier groupe d'un dispositif sur deux ($18_i$, $18_{i+2}$) dans l'agencement est capable d'une connexion à une première sortie (20) et un second groupe de dispositifs intermédiaires ($18_{i-1}$, $18_{i+1}$) est capable d'une connexion à une seconde sortie (22); lesdits moyens d'addition et de différence (26) répondent à la première sortie (20) et à la seconde sortie (22); et ledit agencement de dispositifs capteurs est sur une seule pastille ayant une couche d'anode allongée (72) commune à tous les dispositifs capteurs et un certain nombre de couches de cathode (74a) espacées sur la longueur de la couche d'anode, chaque couche de cathode étant une bande allongée qui s'étend au loin de la couche d'anode, une bande sur deux s'étendant vers le côté opposé.

2. Dispositif de guidage selon la revendication 1, comprenant un générateur (48, 50) d'un signal de déclenchement en réponse au signal de différence en excès d'une valeur préétablie.

3. Dispositif de guidage selon la revendication 2, comprenant un compteur (64) des signaux de déclenchement et un décodeur (62) où le second signal est dérivé du compte du compteur.

4. Dispositif de guidage selon la revendication 3, comprenant un commutateur réglable (24) pour chaque dispositif capteur répondant à la sortie du décodeur et capable de déconnecter ledit dispositif capteur à sa sortie (20 ou 22).

5. Dispositif de guidage selon l'une quelconque des revendications précédentes, comprenant une fenêtre commune (72) pour toutes les couches de cathode où elles sont opposées à la couche d'anode.

6. Dispositif de guidage selon l'une quelconque des revendications précédentes, où le seule pastille a des couches de sortie (80) définissant les deux sorties, une de chaque côté de la couche d'anode et chaque couche de cathode s'étend adjacente à l'une des couches de sortie.

7. Dispositif de guidage selon la revendication 6, où la pastille commune définit un dispositif réglable de commutation à semiconducteur (74, 88, 76a) pour connecter chaque diffusion de cathode à sa couche de sortie.

**Patentansprüche**

1. Spurverfolgungsanordnung für einen optischen Sensor zur Wiedergewinnung von auf Informationsspuren (N), wie z.B. einer kreisförmigen oder spiralförmigen Spur auf einer Video- oder Datenplatte oder einem Computerspeicher, aufgezeichneten Signalen, mit einer Anordnung von Sensorvorrichtungen (18), die für eine Anbringung quer zur Spur vorgesehen ist, und mit Mitteln (24) zur Auswahl eines Paares von benachbarten Sensorvorrichtungen (z.B. $18_i$ und $18_{i+1}$), wobei Summiermittel (38) auf die Ausgangssignale des ausgewählten Paares von Sensorvorrichtungen ansprechen, um ein erstes, für die Information auf der Spur repräsentatives Signal vorzusehen, und Differenzmittel (44, 46) auf die zwei Sensoreinrichtungen ansprechen, um ein Differenzsignal abzuleiten und ein zweites Signal zur Steuerung dessen, welches Paar von zwei benachbarten Sensorvorrichtungen ausgewählt wird, vorzusehen, dadurch gekennzeichnet, daß ein erster Satz von abwechselnden Vorrichtungen ($18_i$, $18_{i+2}$) in der Anordnung mit einem ersten Ausgang (20) verbindbar ist, und ein zweiter Satz von dazwischenliegenden Vorrichtungen ($18_{i-1}$, $18_{i+1}$) mit einem zweiten Ausgang (22)

**0 018 211**

verbindbar ist; daß die Summier- und Differenzmittel (26) auf den ersten Ausgang (20) und den zweiten Ausgang (22) ansprechen; und daß die Anordnung von Sensorvorrichtungen auf einem einzelnen Chip mit einer allen Sensorvor-richtungen gemeinsamen länglichen Anoden-schicht (72) und einer Anzahl von längs der Länge der Anodenschicht in Abständen voneinander vorgesehenen Kathodenschichten (64a) vorliegt, wobei jede Kathodenschicht ein sich von der Anodenschicht weg erstreckender länglicher Streifen ist, wobei sich die Streifen abwechselnd nach gegenüberliegenden Seiten erstrecken.

2. Spurverfolgungsanordnung nach Anspruch 1, mit einem Generator (48, 50) für die Erzeugung eines Triggersignals in Abhängigkeit davon, daß das Differenzsignal einen voreingestellten Wert überschreitet.

3. Spurverfolgungsanordnung nach Anspruch 2, mit einem Zähler (64) für die Triggersignale und einem Dekodierer (62), in dem das zweite Signal von der Zählung des Zählers abgeleitet wird.

4. Spurverfolgungsanordnung nach Anspruch 3, mit einem steuerbaren Schalter (24) für jede Sensorvorrichtung, der auf den Ausgang des Dekodierers anspricht und die Sensorvorrichtung mit ihrem Ausgang (20 oder 22) verbinden kann.

5. Spurverfolgungsanordnung nach einem der vorhergehenden Ansprüche, mit einem gemeinsamen Fenster (72) für alle Kathodenschichten, wo sie der Anodenschicht gegenüberliegen.

6. Spurverfolgungsanordnung nach einem der vorhergehenden Ansprüche, bei der das einzelne Chip Ausgangsschichten (80) aufweist, die die zwei Ausgänge, einen an jeder Seite der Anodenschicht, definieren, und sich jede Kathodenschicht benachbart einer dieser Ausgangsschichten erstreckt.

7. Spurverfolgungsanordnung nach Anspruch 6, bei der das gemeinsame Chip eine steuerbare Halbleiterschaltvorrichtung (74, 88, 76a) zur Verbindung jeder Kathodendiffusion mit ihrer Ausgangsschicht bildet.

FIG. 1

# FIG. 2

FIG. 3A

0 018 211

FIG. 3B

# FIG. 4